# DEMANDE DE BREVET EUROPEEN

(11) **EP 4 390 765 A1**
(43) Date de publication de la demande: **26.06.2024**
(21) Numéro de dépôt: 22307033.5
(22) Date de dépôt: 23.12.2022
(51) Int. Cl.: G06N 3/045, G06N 3/086

(54) **ESTIMATION D'UNE PRODUCTION ELECTRIQUE POUR UN ENSEMBLE DE SITES DE PRODUCTION PAR RESEAUX NEURONAUX INDIVIDUELLEMENT OPTIMISES**

(71) Demandeur: Atos Worldgrid, 95870 Bezons (FR)
(72) Inventeur: POUCHAIN, REMI, La Tronche (FR)
(74) Mandataire: Novagraaf Technologies

(57) **Abrégé**

L'invention concerne un procédé pour l'estimation d'une production électrique d'un ensemble de sites de production, comportant pour chacun desdits site,
- l'acquisition d'un ensemble optimisé de paramètres relatifs au site,
- la fourniture de ces paramètres à un réseau neuronal (associé audit site pour obtenir une production estimée
- ladite estimation étant déterminée en fonction des productions estimées par chacun des réseaux neuronaux ;
chacun desdits réseaux neuronaux étant préalablement déterminé par :
- un entraînement sur un jeu d'entraînement correspondant au site associé audit réseau neuronal et basé sur un ensemble élargi de paramètres relatifs au site, et selon une fonction de coût ;
- une première phase d'optimisation consistant à sélectionner un ensemble optimisé de paramètres parmi l'ensemble élargi de paramètres en fonction de l'influence des paramètres sur l'entraînement du réseau neuronal;
- une seconde phase d'optimisation consistant à modifier itérativement au moins un paramètre structurel du réseau neuronal afin de sélectionner au moins un paramètre structurel optimal, en fonction de l'influence de ce paramètre structurel sur l'entraînement dudit réseau neuronal.

## Description

### DOMAINE DE L'INVENTION

La présente invention est relative à l'estimation d'une production d'énergie sur une zone géographique. Elle s'applique particulièrement à l'estimation prévisionnelle d'une telle production lorsque des sites de production d'énergie sont dépendants d'éléments extérieurs tels que des éléments météorologiques.

### CONTEXTE DE L'INVENTION

Afin de gérer au mieux l'équilibre entre la production d'énergie et la consommation, il est important de pouvoir estimer la production à venir de la façon la plus fiable possible.

La gestion de cet équilibre doit être effectuée à l'échelle d'une zone géographique pertinente, correspondant au réseau de distribution, par exemple une région ou un pays.

Cette zone géographique peut comporter une pluralité de sites de production d'énergie qui peuvent faire appel à des technologies variées pour la production d'énergie. Les sites de productions peuvent notamment être des centrales nucléaires, des centrales thermiques, des centrales solaires, des fermes d'éoliennes, etc.

Pour estimer la production d'énergie dans cette zone, on estime généralement l'énergie produite par l'ensemble des sites de production situés dans la zone, à l'aide d'un modèle générique.

Cependant une telle approche pose le problème de l'identification du ou des sites de production qui pourraient être la cause d'une baisse de production, par exemple à cause d'une panne d'équipement. En outre, du fait de la variété des types de production d'énergie, différents phénomènes peuvent impacter la production des sites, notamment météorologiques, et cette approche globale ne permet pas de mesurer l'impact différentié de ces phénomènes sur les différents sites de production.

Il est donc intéressant d'avoir une estimation de la production d'énergie par site de production et non pas pour l'ensemble de la zone géographique.

Différentes technologies sont utilisées pour modéliser le comportement des sites de productions et ainsi pouvoir prédire une production à venir en fonction de paramètres connus de production, internes au site de production ou externes (données météorologiques, par exemple, qui influent fortement sur la production dans le cas de sites éoliens ou solaires).

Il a été notamment proposé d'utiliser des classifieurs par forêt aléatoire (ou « *random forest classifiers »* en anglais) ou des réseaux neuronaux de longue mémoire à court terme LSTM (pour « *Long Short Term Memory »* en anglais), qui sont capables de prendre en compte un aspect temporel dans les données d'entrées.

Une telle approche est par exemple présentée dans l'article de Mahjoub, S.; Chrifi-Alaoui, L.; Marhic, B.; Delahoche, L. Predicting Energy Consumption Using LSTM, Multi-Layer GRU and Drop-GRU Neural Networks. Sensors 2022, 22, 4062. https://doi.org/ 10.3390/s22114062

Toutefois, en pratique, de tels algorithmes sont très coûteux en termes de calcul et de ressources de stockage, notamment lors de leur entraînement.

En effet, un classifieur par forêt aléatoire génère un arbre décisionnel qui grossit à mesure que le nombre de données d'entraînement augmente. Quant à lui, un réseau neuronal LSTM teste la pertinence de chaque donnée d'entrée antérieure pour la prédiction, afin d'identifier les liens de temporalités.

Ce coût est notamment problématique lorsque des entraînements réguliers sont nécessaires. C'est par exemple le cas lorsqu'un nouveau site de production est mis en place et qu'il ne présente pas ou peu de données d'historique de production d'énergie.

En pratique, donc, on évite les entraînements du modèle et un unique modèle, générique, est utilisé pour l'ensemble des sites de production. Autrement dit, pour chaque site de production, le modèle sera appliqué pour prédire une production future et détecter les éventuels dysfonctionnements et les tendances pour ce site en particulier, mais la prédiction est basée sur un modèle unique et générique.

Compte tenu des spécificités de chaque site, il s'ensuite une diminution de la fiabilité des prédictions.

### RESUME DE L'INVENTION

Le but de la présente invention est de fournir un procédé et un système palliant au moins partiellement les inconvénients précités, et permettent notamment d'améliorer la fiabilité des prédictions de production pour chaque site de production d'une zone géographique donnée.

À cette fin, la présente invention propose un procédé pour l'estimation d'une production électrique d'un ensemble de sites de production, comportant pour chacun desdits site,
- l'acquisition d'un ensemble optimisé de paramètres relatifs audit site,
- la fourniture desdits paramètres à un réseau neuronal associé audit site pour obtenir une production estimée, ladite estimation étant déterminée en fonction des productions estimées par chacun desdits réseaux neuronaux ;
chacun desdits réseaux neuronaux étant préalablement déterminé par :
- un entraînement sur un jeu d'entraînement correspondant au site associé audit réseau neuronal et basé sur un ensemble élargi de paramètres relatifs audit site, et selon une fonction de coût ;
- une première phase d'optimisation consistant à sélectionner un ensemble optimisé de paramètres parmi ledit ensemble élargi de paramètres en fonction de l'influence desdits paramètres sur l'entraînement dudit réseau neuronal ;
- une seconde phase d'optimisation consistant à modifier itérativement au moins un paramètre structurel dudit réseau neuronal afin de sélectionner au moins un paramètre structurel optimal, en fonction de l'influence dudit au moins un paramètre structurel sur l'entraînement dudit réseau neuronal.

Suivant des modes de réalisation préférés, l'invention comprend une ou plusieurs des caractéristiques suivantes qui peuvent être utilisées séparément ou en combinaison partielle entre elles ou en combinaison totale entre elles :
- lesdits paramètres comprennent des données météorologiques correspondant audit site ;
- lesdits réseaux neuronaux sont des réseaux multicouches à propagation avant
- ladite première phase d'optimisation comprend un déclenchement d'entraînements distincts dudit réseau neuronal en remplaçant les valeurs d'au moins un paramètre dudit jeu d'entraînement par d'autres valeurs, et à sélectionner ledit ensemble optimisé de paramètres relatifs audit site, en fonction des différences de l'évolution de ladite fonction de coût.

- dans ladite première phase d'optimisation, chaque paramètre dudit ensemble élargi de paramètres est testé itérativement.
- ladite seconde phase d'optimisation comprend un déclenchement d'entraînements distincts dudit réseau neuronal, en modifiant itérativement un nombre de couches dudit réseau neuronal afin de sélectionner au moins un nombre de couches optimal, puis en modifiant itérativement un nombre de neurones par couches afin de sélectionner un nombre optimal de neurones par couches.
- entre 3 et 10 nombres de couches optimaux sont sélectionnés.
- ladite seconde phase d'optimisation est basée sur un algorithme NEAT.
- lesdits sites de productions appartiennent à un réseau électrique d'une société de production d'énergie.

Un autre objet de l'invention concerne un programme d'ordinateur comprenant des instructions qui, lorsque le programme est exécuté par un ordinateur, conduisent celui-ci à mettre en oeuvre la méthode telle que précédemment décrite.

Un autre objet de l'invention concerne un dispositif pour l'estimation d'une production électrique d'un ensemble de sites de production, comportant pour chacun desdits site, des moyens pour
- l'acquisition d'un ensemble optimisé de paramètres relatifs audit site,
- la fourniture desdits paramètres à un réseau neuronal associé audit site pour obtenir une production estimée,
- ladite estimation étant déterminée en fonction des productions estimés par chacun desdits réseaux neuronaux ;
chacun desdits réseaux neuronaux étant préalablement déterminé par :
- un entrainement sur un jeu d'entrainement correspondant au site associé audit réseau neuronal et basé sur un ensemble élargi de paramètres relatifs audit site, et selon une fonction de coût ;
- une première phase d'optimisation consistant à sélectionner un ensemble optimisé de paramètres parmi ledit ensemble élargi de paramètres en fonction de l'influence desdits paramètres sur l'entrainement dudit réseau neuronal ;
- une seconde phase d'optimisation consistant à modifier itérativement au moins un paramètre structurel dudit réseau neuronal afin de sélectionner au moins un paramètre structurel optimal, en fonction de l'influence dudit au moins un paramètre structurel sur l'entrainement dudit réseau neuronal.

Ainsi, l'invention se base sur le principe de modèles très spécifiques à chaque site de production et créés automatiquement, alors que l'état de la technique propose généralement l'utilisation d'une modèle unique et générique pour tous ces sites.

Selon l'invention, l'estimation des productions de chaque site se base sur un réseau neuronal individuellement optimisé.

La fiabilité et l'évolutivité s'en trouvent ainsi fortement améliorés.

D'autres caractéristiques et avantages de l'invention apparaîtront à la lecture de la description qui suit d'un mode de réalisation préféré de l'invention, donnée à titre d'exemple et en référence aux dessins annexés.

### BREVE DESCRIPTION DES DESSINS

La figure 1 représente schématiquement l'architecture fonctionnelle pour l'estimation d'une prédiction de production pour un site de production d'énergie.
La figure 2 représente schématiquement un exemple d'architecture fonctionnelle pour l'estimation d'une production totale pour un ensemble de sites de production d'énergie.

### DESCRIPTION DETAILLEE DE L'INVENTION

L'invention s'applique particulièrement à l'estimation d'une production électrique totale pour un ensemble de sites de production, qui peuvent par exemple correspondre à une zone géographique. Elle peut s'étendre au cas d'un singleton, c'est-à-dire d'un ensemble réduit à un unique site.

Elle s'applique notamment à la situation où, pour au moins certains de ces sites, la production électrique ne peut être déterminée de façon déterministe par une règle mathématique ou empirique. C'est notamment le cas des sites sur lesquels la production dépend d'éléments extérieurs dont on ne connaît pas l'évolution dans le temps. Du point de vue du système, ces éléments peuvent être vus comme erratiques car sans causalité connue.

Typiquement, ces éléments extérieurs peuvent être des éléments météorologiques. Par exemple, la quantité de vent (durée, force...) impacte fortement la production électrique d'un site éolien. De même, la couverture nuageuse et le rayonnement solaire impactent fortement la production d'un site de panneaux solaires.

Ces éléments sont capturés sous la forme de paramètres qui peuvent être déterminés par des instruments de mesure et former des entrées d'un système d'estimation.

Les paramètres sont propres au site, puisqu'ils peuvent avoir une valeur très locale. Ils peuvent toutefois provenir d'une source distante. Par exemple, une température peut être mesurée très localement, mais d'autres paramètres peuvent être fournis par des fournisseurs de données, par exemple des fournisseurs de données météorologiques

### (par exemple Météo France pour la France, etc.)

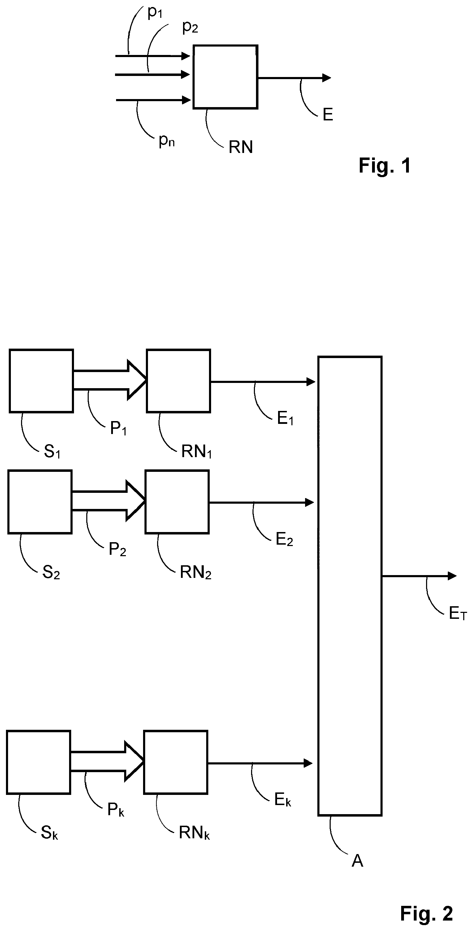

La figure 2 illustre une architecture fonctionnelle et simplifiée pour l'estimation d'une production électrique totale E_{T} d'un ensemble de sites de production électrique S₁, S₂, ..., Sₖ, k représentant le nombre de sites considérés. Ces sites peuvent par exemple appartenir à une zone géographique donnée, et/ou être gérés par une même entité (société de production d'électricité ou branche de celle-ci, ...).

Cette zone géographique peut être une zone correspondant à un réseau électrique, par exemple celui d'une société de production d'énergie.

Pour chaque site, on acquiert un ensemble optimisé, respectivement P₁, P₂, ..., Pₖ, de paramètres relatifs à ce site.

Par « optimisé », on entend que selon l'invention on vise à ne considérer qu'un nombre minimal de paramètres permettant d'obtenir une estimation fiable.

Un plus grand nombre de paramètres peut être disponible pour le site concerné, mais selon l'invention un sous-ensemble, dit « ensemble optimisé » est considéré, c'est-à-dire acquis puis fourni à un réseau neuronal respectif.

Ces paramètres peuvent comprendre par exemple :
- flux de chaleur latente, FLLAT,
- flux de chaleur sensible, FLSEN,
- bilan du rayonnement de grandes longueurs d'onde au sommet de l'atmosphère, FLTHERM
- humidité spécifique, HU2m
- nébulosité à l'étage inférieur, NEBBAS
- nébulosité à l'étage moyen, NEBMOY
- quantité totale de précipitations, PRECIP
- température, T2M
- géopotentiels, Z700hPa, Z850hPa...
- profondeur optique d'aérosol, AOD
- quantité de particules dans l'air, DEPOT
- énergie potentielle collective, CAPE
- vitesse du vent de rafale, FF_RAF10m
- vitesse du vent, FF1000hPa, FF800hPa, FF850gPa, FF900hPa, FF925hPa, FF950hPa...
- composante zonale du vent, U100m, U10m
- composante méridienne du vent, V100m, V10m
- vitesse verticale W600hPa

Ces paramètres correspondent à ceux actuellement mesurés et mis à disposition par un fournisseur de données comme « Météo France ». Les catalogues des données disponibles sont accessibles auprès de Météo-France, notamment sur leur site web : https://donneespubliques.meteofrance.fr/

Ces différents paramètres sont également explicités dans la littérature scientifique, comme notamment dans le mémoire de thèse d'Angélique Godart., « Les précipitations orographiques organisées en bandes dans la région Cévennes-Vivarais. Caractérisation et contribution au régime pluviométrique ». Océan, Atmosphère. Université Joseph-Fourier - Grenoble I, 2009, HAL Id: tel-00431254

D'autres paramètres peuvent être disponibles auprès d'autres fournisseurs ou mesurés localement sur le site de production.

Certains paramètres peuvent également être calculés, c'est-à-dire ne pas résulter, ou pas uniquement, de mesures.

Par exemple, des modules de calcul de la position du soleil et de la lune peuvent fournir ces paramètres qui peuvent être utiles pour certains types de production d'énergie électrique (centrales marémotrices, etc.).

Des modules peuvent également calculer des données de rayonnement comme l'irradiation directe pour l'incidence normale (DNI, pour « Direct irradiation for Normal Incidence » en anglais) ou l'irradiance horizontale globale (GHI pour « Global Horizontal Irradiance »).

L'invention est indépendante, dans son principe, de l'ensemble des paramètres disponibles. Elle trouve un avantage supplémentaire lorsqu'un grand nombre de paramètres est disponible, par son mécanisme d'optimisation des paramètres pris en compte pour la prédiction d'une estimation de production.

L'ensemble optimisé est donc un sous-ensemble de celui des paramètres disponibles. Cet ensemble optimisé, P₁, P₂, ..., Pₖ peut être différent (et est généralement différent) d'un site à l'autre, c'est-à-dire constitué de paramètres différents parmi les paramètres disponibles. Bien évidemment, les valeurs de ces paramètres peuvent également être différentes (pour un même paramètre), puisqu'on s'intéresse aux valeurs locales.

Sur la figure 1, on représente un système d'estimation d'une production électrique pour un unique site.

L'ensemble optimisé de paramètres comprend n paramètres, p₁, p₂, ..., pₙ. Ces n paramètres sont fournis à un réseau neuronal RN.

Ce réseau neuronal RN forme un modèle prédictif, c'est-à-dire qu'il est adapté pour permettre, après entraînement sur un jeu d'entraînement, de fournir une estimation E d'une production électrique à partir d'un vecteur formé par les valeurs des différents paramètres soumis en entrée p₁, p₂, ..., pₙ.

Selon un mode de réalisation de l'invention, le réseau neuronal RN peut être basé sur une architecture simple.

En particulier, selon un mode de réalisation de l'invention, le réseau neuronal RN peut être un réseau multicouche à propagation avant (ou « *Feedforward Neural Network* » en anglais). Ce type de réseau présente le double avantage de la rapidité pour l'entraînement et la prédiction, et d'être architecturalement simple et donc bien adapté aux phases d'optimisation d'au moins un de ses paramètres structurels, qui vont être décrites plus loin.

Il peut notamment être basé sur une architecture initiale comportant un nombre réduit de couches et un nombre de réduit de neurones par couches.

Selon un mode de réalisation de l'invention, les valeurs des paramètres sont prétraitées avant fourniture en entrée du réseau de neurones RN.

Ce prétraitement peut être vu comme un nettoyage des données, c'est-à-dire une conversion entre les valeurs exprimées dans un format propre aux instruments de mesure ou du fournisseur de données vers un format correspondant à leur exploitation par le réseau neuronal RN.

Ce prétraitement comprend la suppression de données incohérentes, c'est-à-dire qui sont à l'extérieur d'une gamme de valeurs possibles ou plausibles, pour le paramètre considéré. Certaines valeurs peuvent être techniquement non possibles et reflètent donc une erreur de mesure manifeste, et doivent donc être écartées. D'autres peuvent être techniquement possibles mais sont statistiquement aberrantes et peuvent également être considérées comme des erreurs de mesure et écartées.

Par exemple, une valeur reflétant une production d'énergie, la nuit, pour un panneau solaire peut être considérée comme une erreur et écartée. De même, une valeur dépassant la production théorique maximale d'une éolienne peut arriver en cas de rafale de vent, mais doit être également écartée.

Le prétraitement peut également comprendre la mise en forme de données. Par exemple, les heures peuvent être converties d'un format 12h, 1h... en 12h, 13h... En effet, prévoir une continuité logique dans les heures diurnes est plus cohérent pour le réseau neuronal RN et permet d'améliorer la prise en compte d'un tel paramètre en apprentissage et, conséquemment, en prédiction.

Le prétraitement peut également comprendre l'enrichissement des paramètres.

Selon l'invention, tout ou partie des paramètres disponibles pour un site de production donné sont fournis à un réseau de neurones RN associé à ce site. On appelle ensemble de paramètre élargi l'ensemble des paramètres fournis au réseau de neurones RN.

Les mécanismes expliqués en rapport avec la figure 1 sont effectivement effectuées pour chaque site de production considéré S₁, S₂, ..., Sₖ, ainsi que représenté dans l'exemple de la figure 2.

Comme évoqué précédemment, les réseaux neuronaux RN₁, RN₂, ..., RNₖ peuvent être basés sur une même architecture initiale mais peuvent correspondre à un modèle prédictif différent et propre au site de production associé. Cette différentiation des réseaux de neurones est atteinte par une phase d'apprentissage (ou d'entraînement).

On rappelle que selon un mode de réalisation de l'invention, le réseau neuronaux sont basés sur une architecture simple (par exemple des réseaux multicouches à propagation avant avec des nombres de couches et de neurones par couches réduits).

Cette phase d'entraînement comprend l'entraînement de chaque réseau neuronal RN₁, RN₂, ..., RNₖ sur la base de l'ensemble élargi de paramètres correspondant et d'une fonction de coût.

Chaque site dispose de paramètres et de valeurs de paramètres différents. Aussi chaque réseau neuronal RN₁, RN₂, ..., RNₖ fait l'objet d'un apprentissage propre. Chaque réseau neuronal RN₁, RN₂, ..., RNₖ forme donc un modèle prédictif propre au site de production, défini par ses paramètres internes. Ces paramètres internes comprennent les poids synaptiques du réseau neuronal RN₁, RN₂, ..., RNₖ mais aussi des paramètres structuraux (nombre de couches, nombre de neurones par couches...).

La fonction de coût (ou « *loss fonction* » en anglais) peut être par exemple la racine de l'erreur quadratique moyenne normalisée ou l'erreur moyenne normalisée, entre la sortie du réseau neuronal et la sortie souhaitée.

L'ensemble d'apprentissage associe donc, de façon classique, un vecteur formé de valeurs des paramètres d'entrée à une sortie souhaitée, appelée typiquement étiquette.

Cet ensemble d'apprentissage peut être constitué à partir des données historiques de chaque site. A défaut de données historiques disponibles (dans le cas d'un nouveau site par exemple), un historique d'un autre site du même type et/ou d'une région proche, pourra être utilisé.

Selon l'invention, la phase d'entraînement (ou apprentissage) comprend en outre des phases d'optimisation.

Une première phase d'optimisation consiste à sélectionner un ensemble optimisé de paramètres parmi l'ensemble élargi de paramètres, pour chaque site considéré.

Cette sélection est effectuée en fonction de l'influence des paramètres sur l'entraînement du réseau neuronal RN₁, RN₂, ..., RNₖ.

La première phase d'entraînement basée sur l'ensemble élargie de paramètres peut fournir une base de départ, à partir de laquelle on peut tester différents sous-ensembles afin d'obtenir un ensemble optimisé qui permet à la fois de diminuer le nombre des paramètres à considérer et d'obtenir de bonnes caractéristiques prédictives du réseau neuronal RN₁, RN₂, ..., RNₖ.

Autrement dit, il s'agit de retirer les paramètres qui n'ont que peu d'influence dans les prédictions effectuées par le réseau neuronal RN₁, RN₂, ..., RNₖ.

Le pourcentage d'influence d'un paramètre peut par exemple être estimé en comparant le résultat de la fonction de coût pour l'ensemble élargi de paramètres et pour ce même ensemble en remplaçant les valeurs de ce paramètre par d'autres valeurs, dans tout ou partie du jeu d'entraînement. Ces autres valeurs peuvent par exemple être des valeurs aléatoires.

On peut alors comparer l'évolution de la fonction de coût, par exemple en regardant le résultat de celle-ci lorsque le jeu d'entraînement a été soumis au réseau neuronal RN₁, RN₂, ..., RNₖ.

Si le résultat n'est pas substantiellement différant, c'est que ce paramètre n'a que peu d'influence et peut être supprimé.

Afin de former un ensemble optimisé de paramètres, on peut supprimer de cette façon tous les paramètres qui ont une influence inférieure à un certain seuil, c'est-à-dire qui ne modifient pas le résultat de la fonction de coût au-delà de ce seuil. A titre d'exemple, le seuil peut être de 0,1 %.

Selon un mode de réalisation de l'invention, cette phase peut être mise en place en testant itérativement chaque paramètre de l'ensemble élargi de paramètre. Une décision est prise pour chaque paramètre de sorte à former en sortie l'ensemble optimisé de paramètres.

Selon un mode de réalisation de l'invention, cette phase d'optimisation est effectuée automatiquement et de façon répétée dans le temps. En effet, il est constaté que certains paramètres possèdent une corrélation avec la période de l'année et/ou la météorologie, de sorte que l'influence de certains paramètres peut être plus ou moins importante au cours du temps. Réactualiser l'ensemble optimisé de paramètres permet donc d'améliorer encore les performances du mécanisme prédictif d'estimation d'une production d'électricité.

Une seconde phase d'optimisation consiste à modifier itérativement au moins un paramètre structurel du réseau neuronal RN₁, RN₂, ..., RNₖ, afin de sélectionner au moins un paramètre structurel optimal, en fonction de l'influence de ce paramètre structurel sur l'entraînement du réseau neuronal.

On rappelle que les paramètres structurels d'un réseau neuronal comprennent notamment un nombre de couches, un nombre de neurones par couches, etc.

Selon l'invention, donc, la structure de chaque réseau neuronal RN₁, RN₂, ..., RNₖ peut différer pour chaque site de production S₁, S₂, ..., Sₖ.

Selon un mode de réalisation de l'invention, cette seconde phase d'optimisation est basée sur l'algorithme NEAT (pour « NeuroEvolution of Augmented Topologies » en anglais).

Cet algorithme a été présenté dans l'article « Efficient Evolution of Neural Network Topologies » de Kenneth O. Stanley et Risto Miikkulainen, in Proceedings of the 2002 Congress on Evolutionary Communication (CEC'02), IEEE.

Il se base sur un principe d'algorithme génétique où la génération de nouvelles structures à tester est effectuée par mutation aléatoire à partir d'une structure précédemment testée, et par combinaison de différentes structures précédemment testées. A chaque itération, une étape de sélection peut ne conserver que les structures intéressantes (c'est-à-dire fournissant une efficience supérieure à un seuil donné).

Selon un mode de réalisation de l'invention, cette seconde phase d'optimisation comprend, pour chaque site de production :
- la modification itérative d'un nombre de couches du réseau neuronal afin de sélectionner un nombre de couches optimal, puis,
- la modification itérative d'un nombre de neurones par couches afin de sélectionner un nombre optimal de neurones par couches.

Les deux étapes peuvent être effectuées la seconde à la suite de la première.

Dans la première étape, l'algorithme agit sur le nombre de couches à partir du modèle simple qui a été préalablement entraîné. Ainsi qu'expliqué plus haut, ce modèle peut être un réseau neuronal (ou perceptron) multicouche.

L'algorithme propose un nombre donné de modèles appelé « patiences », par exemple entre 3 et 10. Ces modèles correspondent à un ensemble de paramètres structuraux définissant le réseau neuronal, c'est-à-dire ici un nombre de couches. Ce nombre peut être réduit ou augmenté par rapport au réseau initial.

Chaque réseau neuronal proposé est entraîné à partir du jeu d'apprentissage puis évalué via la fonction de coût.

Dans la seconde étape, le même principe est appliqué pour le nombre de neurones pour chaque couche (le nombre de couches étant alors fixe pendant cette étape).

Ainsi, chaque réseau neuronal proposé est entraîné à partir du jeu d'apprentissage puis évalué via la fonction de coût.

Tant que le gain de performance est supérieur à un seuil, on itère en prenant comme structure de base celle qui a obtenu la meilleure performance à l'itération précédente.

Le processus itératif s'arrête lorsqu'aucune nouvelle structure ne peut être proposée améliorant substantiellement la performance (c'est-à-dire au-dessus d'un seuil de gain donné). Les paramètres structuraux correspondant au réseau neuronal présentant les meilleures performances sont alors sélectionnées.

Le même processus d'optimisation est réalisé pour chaque site,

En fin de la phase d'apprentissage, chaque site est ainsi associé à un réseau neuronal distinct tant par les paramètres structurels que par les poids synaptiques qui ont fait l'objet d'apprentissage sur la base de jeux d'apprentissage distincts, et sur des ensembles optimisés de paramètres également distincts.

La phase de prédiction consiste à présenter à chaque réseau neuronal un vecteur de paramètres (appartenant à l'ensemble optimisé correspondant) n'appartenant à l'ensemble d'apprentissage et à obtenir des productions estimés E₁, E₂, ..., Eₖ en sortie de ces réseaux neuronaux, respectivement RN₁, RN₂, ..., RNₖ.

L'estimation de production électrique totale E_{T} pour la zone peut ensuite être estimé par des moyens de calcul A en fonction des productions estimés par chacun des réseaux neuronaux RN₁, RN₂, ..., RNₖ, correspondant chacune à un site donné de la zone en question.

Cette estimation de production électrique totale E_{T} peut être la somme des productions estimés pour chaque site, E₁, E₂, ..., Eₖ

Bien entendu, la présente invention n'est pas limitée aux exemples et au mode de réalisation décrits et représentés, mais elle est susceptible de nombreuses variantes accessibles à l'homme de l'art.

## Revendications

1. Procédé pour l'estimation (E_{T}) d'une production électrique d'un ensemble de sites de production (S₁, S₂, ..., Sₖ), comportant pour chacun desdits site,
- l'acquisition d'un ensemble optimisé (P₁, P₂,... Pₖ) de paramètres relatifs audit site,
- la fourniture desdits paramètres à un réseau neuronal (RN₁, RN₂, ..., RNₖ) associé audit site pour obtenir une production estimée (E₁, E₂, ..., Eₖ),
ladite estimation (E_{T}) étant déterminée en fonction des productions estimées (E₁, E₂, ..., Eₖ) par chacun desdits réseaux neuronaux (RN₁, RN₂, ..., RNₖ) ;
chacun desdits réseaux neuronaux (RN₁, RN₂, ..., RNₖ) étant préalablement déterminé par :
- un entraînement sur un jeu d'entraînement correspondant au site associé audit réseau neuronal (RN₁, RN₂, ..., RNₖ) et basé sur un ensemble élargi de paramètres relatifs audit site, et selon une fonction de coût ;
- une première phase d'optimisation consistant à sélectionner un ensemble optimisé de paramètres parmi ledit ensemble élargi de paramètres en fonction de l'influence desdits paramètres sur l'entraînement dudit réseau neuronal (RN₁, RN₂, ..., RNₖ);
- une seconde phase d'optimisation consistant à modifier itérativement au moins un paramètre structurel dudit réseau neuronal (RN₁, RN₂, ..., RNₖ) afin de sélectionner au moins un paramètre structurel optimal, en fonction de l'influence dudit au moins un paramètre structurel sur l'entraînement dudit réseau neuronal (RN₁, RN₂, ..., RNₖ).

2. Procédé selon la revendication précédente, dans lequel lesdits paramètres comprennent des données météorologiques correspondant audit site.

3. Procédé selon l'une des revendications 1 ou 2, dans lequel lesdits réseaux neuronaux (RN₁, RN₂, ..., RNₖ) sont des réseaux multicouches à propagation avant

4. Procédé selon l'une des revendications précédentes, dans lequel ladite première phase d'optimisation comprend un déclenchement d'entraînements distincts dudit réseau neuronal (RN₁, RN₂, ..., RNₖ) en remplaçant les valeurs d'au moins un paramètre dudit jeu d'entraînement par d'autres valeurs, et à sélectionner ledit ensemble optimisé de paramètres relatifs audit site, en fonction des différences de l'évolution de ladite fonction de coût.

5. Procédé selon l'une des revendications précédentes, dans lequel, dans ladite première phase d'optimisation, chaque paramètre dudit ensemble élargi de paramètres est testé itérativement.

6. Procédé selon l'une des revendications indépendantes, dans lequel ladite seconde phase d'optimisation comprend un déclenchement d'entraînements distincts dudit réseau neuronal (RN₁, RN₂, ..., RNₖ), en
- modifiant itérativement un nombre de couches dudit réseau neuronal (RN₁, RN₂, ..., RNₖ) afin de sélectionner au moins un nombre de couches optimal, puis
- modifiant itérativement un nombre de neurones par couches afin de sélectionner un nombre optimal de neurones par couches.

7. Procédé selon la revendication précédente, dans lequel entre 3 et 10 nombres de couches optimaux sont sélectionnés.

8. Procédé selon l'une des revendications 6 ou 7, dans lequel ladite seconde phase d'optimisation est basée sur un algorithme NEAT.

9. Procédé selon l'une des revendications précédentes, dans lequel lesdits sites de productions appartiennent à un réseau électrique d'une société de production d'énergie.

10. Programme d'ordinateur comprenant des instructions qui, lorsque le programme est exécuté par un ordinateur, conduisent celui-ci à mettre en oeuvre la méthode selon l'une des revendications précédentes.

11. Dispositif pour l'estimation (E_{T}) d'une production électrique d'un ensemble de sites de production (S₁, S₂, ..., Sₖ), comportant pour chacun desdits site, des moyens pour
- l'acquisition d'un ensemble optimisé (P₁, P₂,... Pₖ) de paramètres relatifs audit site,
- la fourniture desdits paramètres à un réseau neuronal (RN₁, RN₂, ..., RNₖ) associé audit site pour obtenir une production estimée (E₁, E₂, ..., Eₖ)
- ladite estimation (E_{T}) étant déterminée en fonction des productions estimés (E₁, E₂, ..., Eₖ) par chacun desdits réseaux neuronaux (RN₁, RN₂, ..., RNₖ) ;
chacun desdits réseaux neuronaux (RN₁, RN₂, ..., RNₖ) étant préalablement déterminé par :
- un entrainement sur un jeu d'entrainement correspondant au site associé audit réseau neuronal (RN₁, RN₂, ..., RNₖ) et basé sur un ensemble élargi de paramètres relatifs audit site, et selon une fonction de coût ;
- une première phase d'optimisation consistant à sélectionner un ensemble optimisé de paramètres parmi ledit ensemble élargi de paramètres en fonction de l'influence desdits paramètres sur l'entrainement dudit réseau neuronal (RN₁, RN₂, ..., RNₖ);
- une seconde phase d'optimisation consistant à modifier itérativement au moins un paramètre structurel dudit réseau neuronal (RN₁, RN₂, ..., RNₖ) afin de sélectionner au moins un paramètre structurel optimal, en fonction de l'influence dudit au moins un paramètre structurel sur l'entrainement dudit réseau neuronal (RN₁, RN₂, ..., RNₖ).
